**Europäisches Patentamt**

**European Patent Office**

**Office européen des brevets**

(11) Veröffentlichungsnummer : **0 038 991**
**B1**

(12) **EUROPÄISCHE PATENTSCHRIFT**

(45) Veröffentlichungstag der Patentschrift :
13.06.84

(21) Anmeldenummer : **81102822.4**

(22) Anmeldetag : **13.04.81**

(51) Int. Cl.³ : **H 03 H 15/02**

(54) Aus CTD-Elementen bestehende, mit einer vorgebbaren Abtast- und Taktfrequenz f tief T betriebene elektrische Filterschaltung.

(30) Priorität : 25.04.80 DE 3016082

(43) Veröffentlichungstag der Anmeldung :
**04.11.81 Patentblatt 81/44**

(45) Bekanntmachung des Hinweises auf die Patenterteilung : **13.06.84 Patentblatt 84/24**

(84) Benannte Vertragsstaaten :
**AT BE CH FR GB IT LI NL SE**

(56) Entgegenhaltungen :
**DE-B- 2 831 398**
**DE-B- 2 832 795**
**DE-B- 2 836 901**

(73) Patentinhaber : **SIEMENS AKTIENGESELLSCHAFT**
**Berlin und München Wittelsbacherplatz 2**
**D-8000 München 2 (DE)**

(72) Erfinder : **Betzl, Hermann, Dipl.-Ing.**
**Albert-Rosshaupter-Strasse 130**
**D-8000 München 70 (DE)**
Erfinder : **Magerl, Johann, Ing.grad.**
**Sauerbruchstrasse 9**
**D-8000 München 70 (DE)**
Erfinder : **Volejnik, Wilhelm, Dipl.-Ing.**
**Andreasstrasse 9**
**D-8029 Sauerlach (DE)**

**Beschreibung**

Die Erfindung betrifft eine elektrische Filterschaltung, bei der aus CTD-Elementen bestehende CTD-Leitungen mit unidirektionalem Übertragungsverhalten verwendet sind und diese Leitungen mit einer vorgebbaren Abtast- und Taktfrequenz $f_T$ betrieben sind und bei der weiterhin wenigstens ein Resonator vorgesehen ist, der als in sich geschlossene Leiterschleife unidirektionalen Übertragungsverhaltens ausgebildet ist.

Filterschaltungen und Resonatorschaltungen der vorbezeichneten Art in Form von Zweipol- oder Vierpolresonatoren sind bereits aus den deutschen Patentschriften Nr. 24 53 699, Nr. 25 55 835 und der deutschen Auslegeschrift Nr. 28 36 901 bekannt geworden. In diesen Druckschriften ist auch darauf hingewiesen, daß unter CTD-Leitungen einerseits sogenannte BBD-Anordnungen (Bucket Brigade Devices), also sogenannte Eimerkettenschaltungen, und andererseits auch sogenannte CCD-Anordnungen (Charged Coupled Devices) zu verstehen sind. CCD-Schaltungen sind solche Einrichtungen, die nach dem Prinzip der gekoppelten Ladungen arbeiten. Als übergeordneter Begriff für diese beiden Schaltungsarten hat sich die Bezeichnung « CTD-Einrichtung » (Charge Transfer Devices) eingebürgert, und es ist für diese CTD-Leitungen charakteristisch, daß sie aus einer größeren Anzahl, also beispielsweise n einzelnen CTD-Elementen bestehen, die als vollintegrierbare Gesamtanordnungen realisiert werden können. Bekanntlich müssen solche CTD-Anordnungen über ein Taktsignal mit einer vorgebbaren Taktfrequenz $f_T$ betrieben werden, wobei das Taktsignal den einzelnen Umladekondensatoren zugeführt wird. In der Praxis werden dabei sogenannte Mehrphasen-CTD-Anordnungen bevorzugt, deren Taktsignale zueinander phasenverschoben sind, derart, daß benachbarte Umladekapazitäten mit phasenverschobenen Takten betrieben werden. Wenn man demzufolge ein sogenanntes p-Phasentaktsystem (p = 2, 3, 4...) verwendet, dann besteht ein CTD-Element aus p benachbarten Umladekapazitäten. Einzelheiten hierüber finden sich zum Beispiel außerdem in dem Buch « Charge Transfer Devices », Academic Press Inc., New York, San Francisco, London 1975. Auch sind in diesem Buch und den einleitend genannten Druckschriften Schaltungsmöglichkeiten dafür angegeben, wie Signale für die Weiterverarbeitung in einer CTD-Anordnung aufbereitet werden können bzw. wie umgekehrt über CTD-Anordnungen übertragene Signale in andere Signalformen, zum Beispiel Analogsignale, rückverwandelt werden können. In den bereits erwähnten Deutschen Patentschriften sind nun Filterschaltungen angegeben, bei denen solche CTD-Leitungen zu einem in sich geschlossenen resonanzfähigen Ring geschaltet sind, wobei die Resonanzfrequenz dieser Ringe unmittelbar von der Anzahl n der für die in sich geschlossene Leiterschleife verwendeten CTD-Leitungselemente und der Taktfrequenz bestimmt wird. Für die Filtercharakteristik ist mitbestimmend das Verhältnis der Umladekapazitäten der in der Ausgangsleitung verwendeten CTD-Anordnung zu der Umladekapazität der in der geschlossenen Leiterschleife verwendeten CTD-Anordnung.

CTD-Filterschaltungen nach den vorstehend genannten Patentschriften mit gegebenenfalls mehreren in Kette geschalteten Zweipol- oder Vierpolresonatoren haben, wie die dort angegebenen Dimensionierungsformeln zeigen, bei Bandpaßschaltungen mit kleinem relativen Durchlaßbereich $B = \Delta f_{3dB}/f_m < 1\%$ große Werte für die Kapazitäts-Verhältnisse im Zweipol- bzw. Vierpolresonator, das heißt die Umladekapazitäten für die Zu- bzw. die Abnahmeleitungen unterscheiden sich verhältnismäßig stark von den Umladekapazitäten der in den geschlossenen Leiterschleifen zu verwendenden CTD-Leitungen.

Angaben über die Resonanzfrequenz solcher CTD-Resonatoren finden sich auch in der DE-PS 28 31 398 und schließlich ist in der DE-PS 28 32 795 eine Dimensionierung angegeben, nach der das auszusiebende Frequenzband oberhalb der halben Taktfrequenz liegen kann.

Um zur integrierten Herstellung die technologischen Prozesse möglichst zu vereinfachen, wird man deshalb gemäß der der Erfindung zugrundeliegenden Aufgabe bestrebt sein, Unterschiede in den Umladekapazitäten der zu verwendenden CTD-Leitungen zu verkleinern.

Erfindungsgemäß wird diese Aufgabe in der Weise gelöst, daß das auszusiebende Frequenzband vor einer beim Abtasten erfolgenden Umsetzung in eine Frequenzlage, dir einen von Null verschirdenen, unterhalb der halben Taktfrequenz ligenden Durchlaßbereich des Filters darstellt, in seiner Frequenzlage oberhalb der halben Taktfrequenz ($f_T/2$) im Frequenzbereich von $f_T/2$ bis $3 f_T/2$ liegt.

Eine vorteilhafte Anwendungsmöglichkeit ist im Unteranspruch angegeben.

Die Erfindung wird nachstehend anhand der beigefügten Zeichnungen näher erläutert und es zeigt dabei

Figur 1 eine mögliche bekannte Ausgestaltung eines CTD-Filters nach den einleitend genannten Patentschriften,

Figur 2 die erfindungsgemäße Auswahl der Taktfrequenz und damit eine mögliche Anwendung in Trägerfrequenzsystemen, bei denen bekanntlich die Frequenzlage eines bzw. der zu übertragenden Frequenzbänder unter Verwendung von Modulatoren versetzt wird.

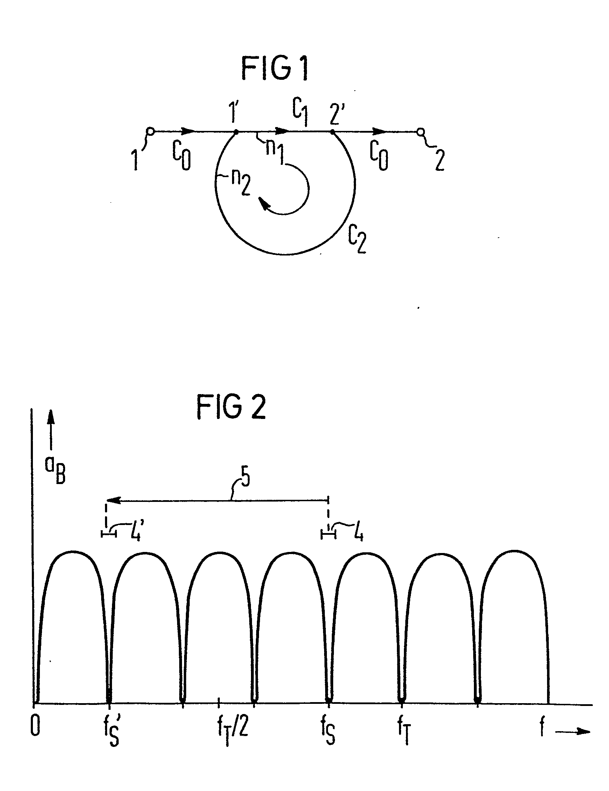

Zum leichteren Verständnis ist in Fig. 1 das Grundkonzept einer CTD-Filterschaltung unter Verwendung eines Zweipolresonators nach den eingangs genannten Patentschriften dargestellt. Mit den Bezugsziffern 1 bzw. 2 sind der Eingang bzw. der Ausgang der Filterschaltung bezeichnet ; die CTD-Eingangsleitung bzw. die CTD-Ausgangsleitung haben die Umladekapazität $C_0$. An den Punkten 1' bzw.

2' ist eine in sich geschlossene Leiterschleife angeschaltet, die aus einem ersten Abschnitt mit der Umladekapazität $C_1$ und einem Abschnitt mit der Umladekapazität $C_2$ besteht. Durch die miteingetragenen Pfeile ist das unidirektionale Übertragungsverhalten dieser CTD-Leitung kenntlich gemacht. Anstelle des in Fig. 1 gezeichneten Zweipolresonators sind auch als Vierpolresonatoren ausgebildete Filterschaltungen anwendbar, wie sie insbesondere durch die eingangs ebenfalls genannte Deutsche Patentschrift 24 53 669 bekannt geworden sind. In Fig. 1 ist indirekt auch darauf hingewiesen, daß aufgrund der bei solchen CTD-Filterschaltungen vorgegebenen Verhältnissen stets eine ganzzahlige Anzahl von CTD-Elementen für die geschlossene Leiterschleife verwendet werden muß, so daß also der Leitungsabschnitt mit der Umladekapazität $C_1$ aus $n_1$ und der Leitungsabschnitt mit der Umladekapazität $C_2$ aus $n_2$ CTD-Elementen besteht. Die in sich geschlossene Leiterschleife hat demzufolge eine ganzzahlige Anzahl $n = n_1 + n_2$ CTD-Elemente. Filter dieser Art haben gemäß ihrem Leitungscharakter periodisch sich wiederholende Durchlaßbereiche bei den Frequenzen $f = af_T/n$ mit $a = 0, 1, 2, \ldots$ . Für schmale Bandbreiten B des Durchlaßbereiches errechnet sich das Kapazitätsverhältnis der Umladekapazitäten näherungsweise nach der Formel $C_2/C_0 \approx 1/\pi B$ für den ersten von $f = 0$ verschieden Durchlaßbereich.

Gemäß Fig. 2 ist erfindungsgemäß von den nachstehend gegebenen Erläuterungen auszugehen. In Fig. 2 ist dabei in Abhängigkeit von der Frequenz f die Dämpfung $a_B$ schematisch aufgetragen. Auch ist zu erkennen, daß das mit 4 bezeichnete auszusiebende Nutzfrequenzband im Bereich um die Signalfrequenz $f_S$ liegt. Der mit 5 bezeichnete Pfeil läßt erkennen, daß durch eine Frequenzumsetzung beim Abtasten am Eingang des Filters der Frequenzbereich 4 umgesetzt wird in den Frequenzbereich 4' in eine Frequenzlage $f_S'$, die zugleich den ersten, von Null verschiedenen Durchlaßbereich des Filters darstellt. Die für die CTD-Leitungen verwendete Taktfrequenz $f_T$ ist ebenfalls zu erkennen und es ist die Frequenzlage $f_S$ des auszusiebenden Nutzfrequenzbandes so gewählt, daß $f_S$ größer als $f_T/2$ ist.

Bei den derzeit zur Anwendung kommenden Trägerfrequenz-systemen und den technologischen Realisierungsmöglichkeiten für solche CTD-Leitungen hat es sich nach den der Erfindung zugrunde liegenden Untersuchungen als vorteilhaft gezeigt, wenn insbesondere das auszusiebende Frequenzband im Bereich von $f_T/2$ bis $3\,f_T/2$ liegt.

Bekanntlich müssen in Trägerfrequenzsystemen auch schmalbandige Bandpaßfilter vorgesehen werden, die der Selektion der hier zu übertragenden Wählsignale dienen und deren Frequenzlage außerhalb des eigentlichen Sprachkanales liegt.

Für die Dimensionierung nach Fig. 2 haben als Beispiel noch folgende Überlegungen Gültigkeit. In allen Fällen, in denen das auszusiebende Frequenzband in seiner Frequenzlage versetzt werden darf oder soll, wie z. B. in den an sich bekannten Trägerfrequenzsystemen der Nachrichtentechnik, gibt es vorteilhafte Resonator-Dimensionierungen mit kleinerem Kapazitätsverhältnis, wenn gemäß der Erfindung vorgegangen wird. Man nutzt dabei die Periodizität des Resonator-Dämpfungsverhaltens aus und wählt die Abtast- und gleichzeitig die Taktfrequenz $f_T$ so, daß das auszusiebende Frequenzband in einem oberhalb $f_T/2$ liegenden Resonator-Durchlaßbereich liegt. In Fig. 2 ist dies am Beispiel eines Ringresonators mit $n = 5$ Ringelementen dargestellt. Dabei wird das im Frequenzbereich um $f_S$ liegende Frequenzband beim Abtasten in die Frequenzlage um $f_S' = /f_T - f_S/ = f_T/n$ nach unten versetzt und ausgefiltert. Für die Filterdimensionierung ist in diesem Fall die relative Bandbreite B' der Filterkurve bei $f_S'$ maßgebend und nicht die im Fall ohne Frequenzumsetzung ($f_T > 2\,f_S$) auf $f_S$ bezogene Bandbreite B:

$$B' = \frac{\Delta f_{3dB}}{f_S'} = \frac{\Delta f_{3dB}}{f_T/n} = \frac{\Delta f_{3dB}}{f_S/(n \pm 1)} = B \cdot (n \pm 1)$$

B' ist um den Faktor $(n \pm 1)$ größer als B. Entsprechend kleiner sind deshalb bei einer Schaltung mit ausgenutzter Frequenzumsetzung die Kapazitätsverhältnisse, die Chip-Fläche sowie der von der unvollständigen Ladungsübertragung herrührende Durchlaßdämpfungsanteil und die absolute Frequenzverschiebung der Durchlaßmittenfrequenz.

**Ansprüche**

1. Elektrische Filterschaltung, bei der aus CTD-Elementen bestehende CTD-Leitungen mit unidirektionalem Übertragungsverhalten verwendet sind und diese Leitungen mit einer vorgebbaren Abtast- und Taktfrequenz $f_T$ betrieben sind und bei der weiterhin wenigstens ein Resonator vorgesehen ist, der als in sich geschlossene Leiterschleife unidirektionalen Übertragungsverhaltens ausgebildet ist, dadurch gekennzeichnet, daß das auszusiebende Frequenzband vor einer beim Abtasten erfolgenden Umsetzung in eine Frequenzlage ($f_S$), die einen von Null verschiedenen, unterhalb der halben Taktfrequenz ($f_T/2$) liegenden Durchlaßbereich des Filters darstellt, in seiner Frequenzlage oberhalb der halben Taktfrequenz ($f_T/2$) im Frequenzbereich von $f_T/2$ bis $3\,f_T/2$ liegt.

2. Filterschaltung nach Anspruch 1, gekennzeichnet durch ihre Verwendung als schmalbandiges Bandpaßfilter, insbesondere als Signalfilter in Trägerfrequenzsystemen.

**0 038 991**

### Claims

1. An electrical filter circuit using CTD-lines consisting of CTD-elements having unidirectional transmission properties, wherein these lines are operated by a predetermined sampling and pulse frequency $f_T$ and wherein furthermore at least one resonator constructed as a conductor loop closed in itself and having unidirectional transmission properties is arranged, characterised in that prior to a transformation into a frequency position ($f_S'$) which represents a pass band of the filter different from zero and below half the pulse frequency ($f_T/2$), the filter band to be filtered out lying in a frequency position above half the pulse frequency ($f_T/2$) in the frequency range of from $f_T/2$ to $3\ f_T/2$.

2. A filter circuit as claimed in Claim 1, characterised by its use as a narrow-band band-pass filter, in particular as a signal filter in carrier frequency systems.

### Revendications

1. Circuit de filtre électrique, dans lequel on utilise les lignes CTD constituées par des éléments CTD possédant un comportement de transmission unidirectionnel et dans lequel ces lignes fonctionnent avec une fréquence d'échantillonnage et d'horloge $f_T$ pouvant être prédéterminée et dans lequel en outre il est prévu au moins un résonateur qui est réalisé sous la forme d'un conducteur en boucle fermé sur lui-même et possédant un comportement de transmission unidirectionnel, caractérisé par le fait qu'avant sa conversion, réalisée lors de l'échantillonnage, en une position en fréquence ($f_S'$) qui représente une bande passante du filtre différant de zéro et située au-dessous de la demi-fréquence d'horloge ($f_T/2$), la bande de fréquences devant être extraite par filtrage est située dans sa position en fréquence au-dessus de la demi-fréquence d'horloge ($f_T/2$) dans la gamme de fréquences comprise entre $f_T/2$ et $3\ f_T/2$.

2. Circuit de filtre suivant la revendication 1, caractérisé par son utilisation en tant que filtre passe-bande à bande étroite, notamment en tant que filtre de signaux dans des systèmes à fréquences porteuses.

## FIG 1

## FIG 2